# EUROPEAN PATENT SPECIFICATION

(11) **EP 1 592 208 B1**
(45) Date of publication and mention of the grant of the patent: **17.12.2008**
(21) Application number: 05009029.9
(22) Date of filing: 25.04.2005
(51) Int. Cl.: H04M 1/02, H05F 3/02, H04B 1/38

(54) **Electrostatic preventing apparatus of mobile terminal and method thereof**
Gerät und Verfahren zum Verhindern von elektrostatischer Aufladung eines mobilen Endgeräts
Appareil et procédé pour la prévention d'accumulation électrostatique d'un terminal mobile

(30) Priority: 30.04.2004 KR 2004030754
(43) Date of publication of application: 02.11.2005
(73) Proprietor: LG ELECTRONICS INC., Seoul (KR)
(72) Inventor: Lee, Sang-Hoon, Anyang Gyeonggi-Do (KR); Park, Byung-Duck, Dongan-Gu Anyang Gyeonggi-Do (KR)
(74) Representative: Beyer, Andreas

(56) References cited:
- EP-A- 1 089 606
- WO-A-20/05125157
- US-A- 5 664 667
- US-B1- 6 580 043
- DATABASE WPI Section EI, Week 200341 Derwent Publications Ltd., London, GB; Class T04, AN 2003-436860 XP002368259 & KR 2003 006 478 A (YOU EAL ELECTRONICS CO LTD) 23 January 2003 (2003-01-23)
- DATABASE WPI Section EI, Week 200346 Derwent Publications Ltd., London, GB; Class X26, AN 2003-491123 XP002368260 & KR 2003 022 470 A (LG ELECTRONICS INC) 17 March 2003 (2003-03-17)

## Description

### BACKGROUND OF THE INVENTION

### 1. Field of the Invention

The present invention relates to a mobile terminal, and more particularly, to an electrostatic preventing apparatus of a mobile terminal capable of preventing a mal-operation of the mobile terminal due to an electrostatic applied to the periphery of a key pad and capable of preventing inner components of the mobile terminal from being damaged, and a method thereof.

### 2. Description of the Conventional Art

Generally, a mobile terminal is a communication device for performing a voice transmission/reception with a counter party anywhere with being simply carried by a user. As information communication technique develops, the mobile terminal performs not only a function for transmitting/receiving text messages to/from a counter party, an internet accessing function, and a TV watching function, but also a camera function for photographing an object as a stationary image or a moving image and then transmitting/receiving the photographed image to/from a counter party. Fields to which the mobile terminal is applied are being continuously increased.

The mobile terminal can be divided into a bar type mobile terminal, a flip type mobile terminal, a folder type mobile terminal, a slider type mobile terminal according to an external form thereof.

The bar type mobile terminal is provided with a body having a PCB therein, keys, a display, a speaker, a mike, etc.

The flip type mobile terminal includes a body, and a flip rotatably coupled to one side of the body. The body of the flip type mobile terminal is provided with keys, a display, a speaker, etc., and the flip is provided with a mike.

The folder type mobile terminal includes a body, and a folder rotatably coupled to one side of the body. The body of the folder type mobile terminal is provided with keys, a mike, etc., and the folder is provided with a display, a speaker, etc.

The slider type mobile terminal includes a body, and a slider slidably coupled to one side of the body. The body of the slider type mobile terminal is provided with keys and a mike, and the slider is provided with a display and a speaker.

The mobile terminals perform a reception calling by pressing a reception key to communicate with a counter party at the time of receiving a call from the counter party, and perform an originating calling by pressing input keys and then pressing a send key to communicate with a counter party at the time of originating a call to the counter party.

At the time of accessing to the internet or sending a text message by using the mobile phone, input keys are used.

However, while a user inputs a signal such as a message, etc. by using keys, electrostatic is generated by the user's contact to the keys or by a contact between an object and the keys to be introduced into the mobile terminal through gaps between the keys. The electrostatic introduced into the mobile terminal damages software of the mobile terminal by noise thereby to generate a mal-operation of the mobile terminal, and sometimes damages hardware. As a function of the mobile terminal becomes diverse and a performance thereof is enhanced, a damage due to the electrostatic is increased.

Recently, an electrostatic preventing unit is provided at a surface of keys, etc. to prevent electrostatic from being applied to the mobile terminal. However, it is difficult to completely prevent electrostatic applied to the periphery of the keys by only the electrostatic preventing unit. Accordingly, a damage due to electrostatic can not be completely solved.

US-A-5 664 667 discloses a keypad arranged above a printed board. The underside surface of a non-working portion of the keypad is covered by an insulating resin film so as to form an electrically conductive light-reflecting layer which is grounded to an earth portion.

KR-A-2003 006 478 discloses a keypad for a mobile terminal having the features set out in the preamble of claim 1.

KR-A-2003 022 470 discloses an organic electroluminescence device, wherein on the outside of the organic electroluminescence device a conductive discharging route is formed and is connected to a grounding wire for discharging static electricity.

EP-A-1 089 606 discloses a display frame having an integrated electrostatic discharge shield. It consists of an electrically conductive extended display frame arranged to essentially cover a keypad, a display unit and a loudspeaker and is coupled to a ground potential member so as to protect the electronic devices against electrostatic discharges.

US-B-6 580 043 discloses a contact element for an electrical device, wherein the contact element has an electrically conductive coating deposited on a switching mat, whereby electrostatic discharge transmitted to a key will be reflected by the electrically conductive coating into the casing of the electrical device.

### SUMMARY OF THE INVENTION

Therefore, an object of the present invention is to provide an electrostatic preventing apparatus of a mobile terminal capable of preventing a mal-operation of the mobile terminal due to an electrostatic applied to the periphery of a key pad to be introduced into the mobile terminal and capable of preventing inner components of the mobile terminal from being damaged, and a method thereof.

To achieve these and other advantages and in accordance with the purpose of the present invention, as embodied and broadly described herein, there is provided a mobile terminal comprising the features set out in claim 1.

The foregoing and other objects, features, aspects and advantages of the present invention will become more apparent from the following detailed description of the present invention when taken in conjunction with the accompanying drawings.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 is a disassembled perspective view showing a body of a mobile terminal having an electrostatic preventing apparatus according to the present invention;
FIG. 2 is a sectional view showing the body of a mobile terminal having an electrostatic preventing apparatus according to the present invention;
FIG. 3 is a disassembled perspective view showing a body of a mobile terminal provided with an electron emitting pad to which an electrostatic preventing apparatus according to the present invention is applied;
FIG. 4 is a disassembled perspective view showing a body of a mobile terminal having an electrostatic preventing apparatus according to a second embodiment of the present invention;
FIG. 5 is a disassembled perspective view showing a body of a mobile terminal having an electrostatic preventing apparatus according to a third embodiment of the present invention;
FIG. 6 is a disassembled perspective view showing a body of a mobile terminal having an electrostatic preventing apparatus according to a fourth embodiment of the present invention;
FIGs. 7 and 8 are sectional views showing modification examples of a key pad of the electrostatic preventing apparatus of a mobile terminal according to the present invention; and
FIG. 9 is a flowchart showing a method for protecting electrostatic in a mobile terminal according to one embodiment of the present invention.

### DETAILED DESCRIPTION OF THE PREFERRED EMBODIMENTS

Reference will now be made in detail to the preferred embodiments of the present invention, examples of which are illustrated in the accompanying drawings.

Hereinafter, an electrostatic preventing apparatus of a mobile terminal according to the present invention will be explained in more detail.

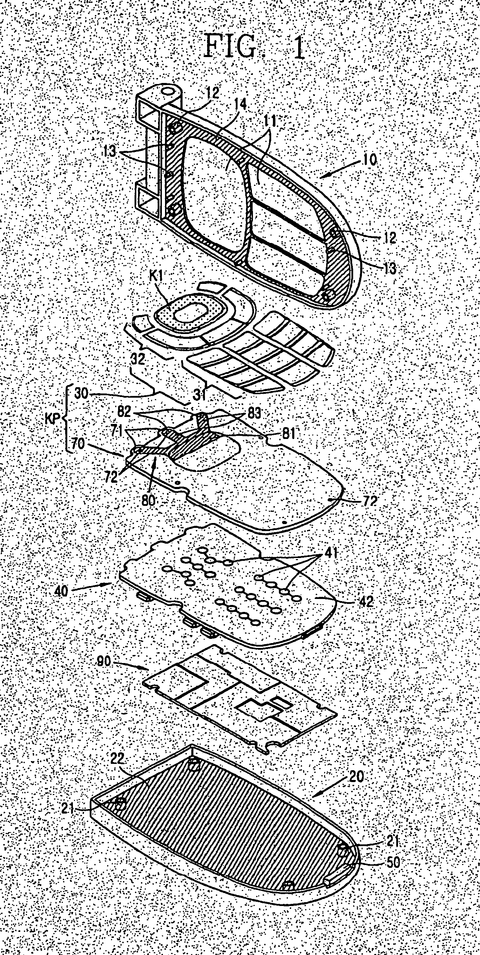

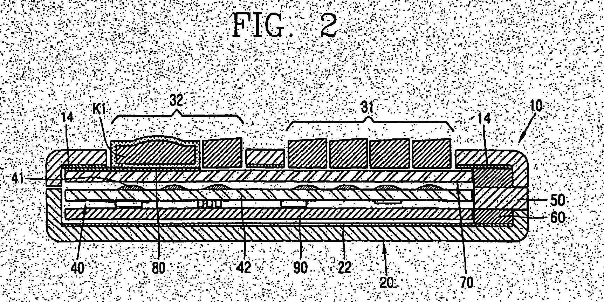

FIG. 1 is a disassembled perspective view showing a body of a mobile terminal having an electrostatic preventing apparatus according to the present invention, and FIG. 2 is a sectional view showing the body of a mobile terminal having an electrostatic preventing apparatus according to the present invention.

As shown, the mobile terminal comprises: a body including a casing composed of a front case 10 and a rear case 20, a key pad KP having a plurality of keys 30 and mounted in the casing so that the keys 30 can be exposed to outside of the casing, and a main board provided with a plurality of dome switches 41 corresponding to the keys of 30 the key pad and mounted in the casing; and an electrostatic preventing apparatus.

The front case 10 is provided with a plurality of key holes 11 for inserting the keys 30 of the key pad KP at a front surface thereof, and a plurality of boss portions 12 for coupling by a screw (not shown) are protruded at an inner surface of the front case. Also, a plurality of stopping pins 13 are protruded at the inner surface of the front case. The front case 10 is provided with a ground path 14 for conducting and discharging electrostatic. The ground path 14 of the front case is a conductive thin film formed at an entire surface of the inner surface of the front case 10. The conductive thin film is preferably formed by spraying an EMI material. The conductive thin film has preferably a resistance value less than 1.2Ω.

The rear case 20 is provided with a plurality of boss portions 21 corresponding to the boss portions 12 of the front case 10 at an inner surface thereof. The rear case 20 is also provided with a ground path 22 for conducting and discharging electrostatic. The ground path 22 of the rear case is a conductive thin film formed at an entire surface of the inner surface of the rear case 20. The conductive thin film is preferably formed by spraying an EMI material. The conductive thin film has preferably a resistance value less than 1.2Ω.

Preferably, the ground path 14 of the front case 10 and the ground path 22 of the rear case 20 are connected to each other at the time of coupling the front case 10 and the rear case 20 to each other. The ground path 14 formed at the boss portions 12 of the front case 10 is connected to the ground path 22 formed at the boss portion 21 of the rear case 20 by a contact.

An I/O connector 50 is mounted at the end of one side of the rear case 20. The I/O connector 50 is formed of a conductive metal. Preferably, the ground path 22 of the rear case 20 is electrically connected to the I/O connector 50. The ground path 22 of the rear case 20 is electrically connected to the I/O connector 50 by a conductive gasket 60.

The front case 10 and the rear case 20 are formed of a plastic material.

The key pad KP is composed of a pad 70 formed of a flexible material to have a certain thickness and an area, and a plurality of keys 30 attached to the pad 70.

The pad 70 is provided with a plurality of extension portions 71 at one side thereof, and a through hole 72 is respectively formed at the extension portions 71. At the time of coupling the key pad KP and the front case 10 to each other, the stopping pins 13 of the front case 10 are respectively inserted into the through holes 72 formed at the extension portions 71. A plurality of the through holes 72 are also formed at parts of the pad 70 except the extension portions 71. The through holes 72 are positioned at parts corresponding to the stopping pins 13 of the front case 10. The pad 70 is formed of a rubber material.

The keys 30 of the key pad include number keys 31 represented as numbers and characters for inputting numbers and characters, and operation keys 32 represented as operation signals for inputting operation signals.

The number keys 31 and the operation key 32 are respectively attached to one surface of the pad 70. The number keys 31 and the operation keys 32 are generally arranged at different regions.

A conductive layer is formed either on the number keys 31 or on the operation keys 32. Preferably, a conductive layer is formed on a key that has the largest area or that is the most frequently used among the operation keys 32. The reason why the conductive layer is formed on the key is for a good appearance of the product.

The key pad KP is provided with a conducting path 80 for conducting electrostatic. The conducting path 80 is formed of a thin film patterned on a surface of the pad 70 to which the keys 30 are attached. The conducting path 80 includes a first ground portion 81 formed at a region to which a key K1 on which a conductive layer is formed is attached as a certain shape for contacting the key K1 on which a conductive layer is formed, second ground portions 82 respectively formed at the extension portions 71 of the pad, and a connection portion 83 for connecting the first ground portion 81 to the second ground portions 82.

The thin film is preferably formed of one of carbon, copper, gold, silver, etc. A resistance value of the conducting path 80 is preferably less than 10Ω.

As another modification example, the conducting path 80 provided at the key pad KP is formed of a conductive thin film tape (not shown) having a certain shape. The conductive thin film tape is attached to the pad 70.

The main board 40 includes a substrate 42 having a certain shape, components mounted at one surface of the substrate 42, and a plurality of dome switches 41 provided at another surface of the substrate 42. The keys 30 of the key pad KP respectively correspond to the dome switches 41.

An unexplained reference numeral 90 denotes an inner cover.

Components of the body are assembled to one another as follows.

The key pad KP is coupled to the front case 10 so that the keys 30 of the key pad KP can be positioned at the key holes 11 of the front case 10. The stopping pins 13 of the front case 10 are respectively inserted into the through holes 11 of the key pad KP, and the second ground portion 82 of the conducting path 80 formed at the key pad KP is connected to the ground path 14 formed at an inner side of the front case 10. The key K1 on which a conductive layer is formed among the keys 30 of the key pad KP is in contact with the first ground portion 81 of the conducting path 80 formed at the pad 70.

The main board 40 is positioned at the key pad KP so that a surface of the main board 40 where the dome switches 41 are formed can be in contact with a surface of the key pad KP where the keys 30 are not positioned. Also, the inner cover 90 is in contact with the main board 40.

The front case 10 and the rear case 20 are coupled to each other by respectively coupling the boss portions 12 of the front case 10 to the boss portions 21 of the rear case 20 by screws (not shown).

An operation of the electrostatic preventing apparatus of the mobile terminal according to the present invention will be explained as follows.

When electrostatic is applied to the periphery of the keys 30 as the mobile phone is in contact with an object or a user presses the keys 30, the electrostatic is introduced into the key K1 on which a conductive layer is formed. Then, the electrostatic flows on the ground pathes 14 and 22 formed at the casing through the conducting path 80 formed at the key pad KP, and then is discharged outward through the casing, the screws coupled to the casing, or the I/O connector 50 mounted at the casing.

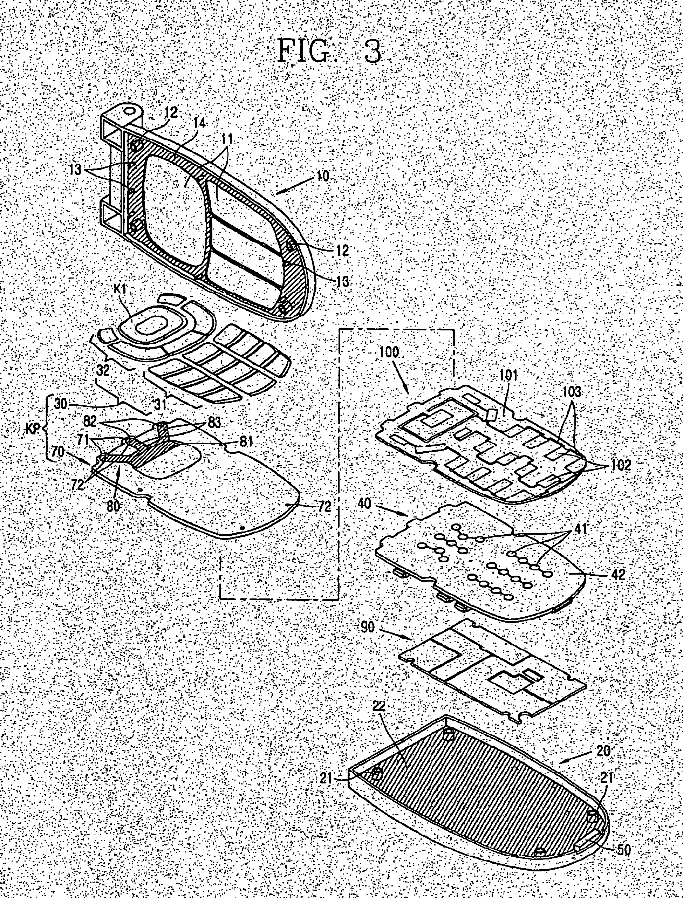

FIG. 3 is a disassembled perspective view showing a body of a mobile terminal provided with an electron emitting key pad to which an electrostatic preventing apparatus according to the present invention is applied. The same reference numerals were given to the same parts as those of the aforementioned FIGs.

The front case 10, the rear case 20, the main board 40, and the inner cover 90 have the same constructions as those of the aforementioned FIGs.

The key pad KP has the same construction as the aforementioned construction, and the pad thereof is formed of a transparent material.

The electron emitting key pad 100 includes a pad 101, and electron emitting lamps 102 arranged at the pad 101. The electron emitting lamps 120 are connected to one another by a connection line 103 patterned on the pad 110, and are lightened by a driving circuit portion (not shown).

The electron emitting key pad 100 is positioned between the main board 40 and the key pad KP, and can be inserted into the pad 70 of the key pad KP.

The mobile terminal having the electron emitting key pad 100 implements more peculiar appearance as light is emitted from the electron emitting lamp 102 of the electron emitting key pad 100.

A second embodiment of the electrostatic preventing apparatus of the mobile terminal according to the present invention will be explained as follows.

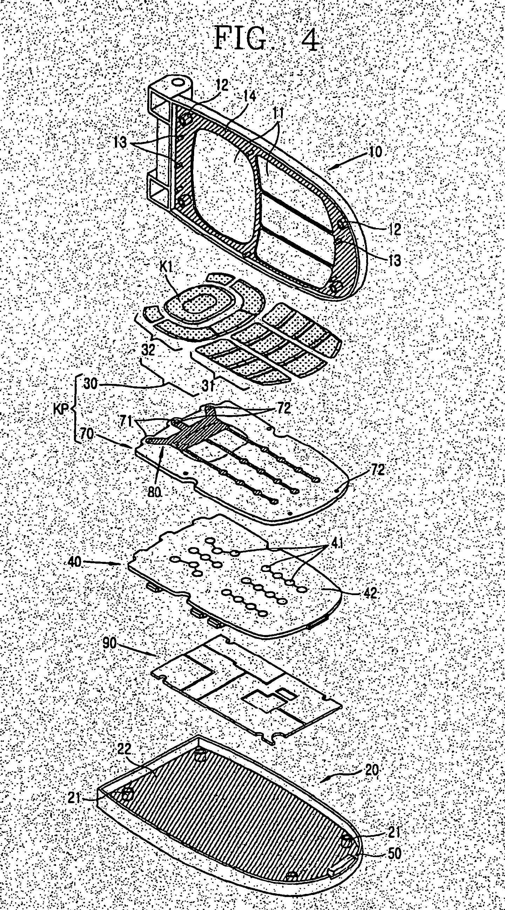

FIG. 4 is a disassembled perspective view showing a body of a mobile terminal having an electrostatic preventing apparatus according to the second embodiment of the present invention. The same reference numerals were given to the same parts as those of the aforementioned FIGs.

The front case 10, the rear case 20, and the main board 40 have the same constructions as those of the aforementioned FIGs. A conductive layer is formed on plural keys or the entire keys among the number keys 31 and the operation keys 32 of the key pad KP.

A pad 70 constituting the key pad KP is provided with a conducting path 80 at one surface thereof. The conducting path 80 is for connecting keys on which a conductive layer is formed. The keys 30 are attached to a surface of the pad 70 where the conducting path 80 is formed. The conducting path 80 is formed of a thin plate patterned as a certain shape, and the thin plate is formed of a conductive material such as carbon, copper, gold, silver, etc.

When the key pad KP is mounted at the front case 10, the conducting path 80 formed at the key pad KP is in contact with the ground path 14 formed at the front case 10.

An operation of the electrostatic preventing apparatus of the mobile terminal according to the second embodiment of the present invention will be explained as follows.

When electrostatic is applied to the periphery of the keys 30, the electrostatic is introduced into the keys 30 on which a conductive layer is formed. Then, the electrostatic flows on the ground pathes 14 and 22 formed at the casing through the conducting path 80 formed at the key pad KP, and then is discharged outward through the casing, the screws coupled to the casing, or the I/O connector 50 mounted at the casing.

An operation of the electrostatic preventing apparatus of the mobile terminal according to a third embodiment of the present invention will be explained as follows.

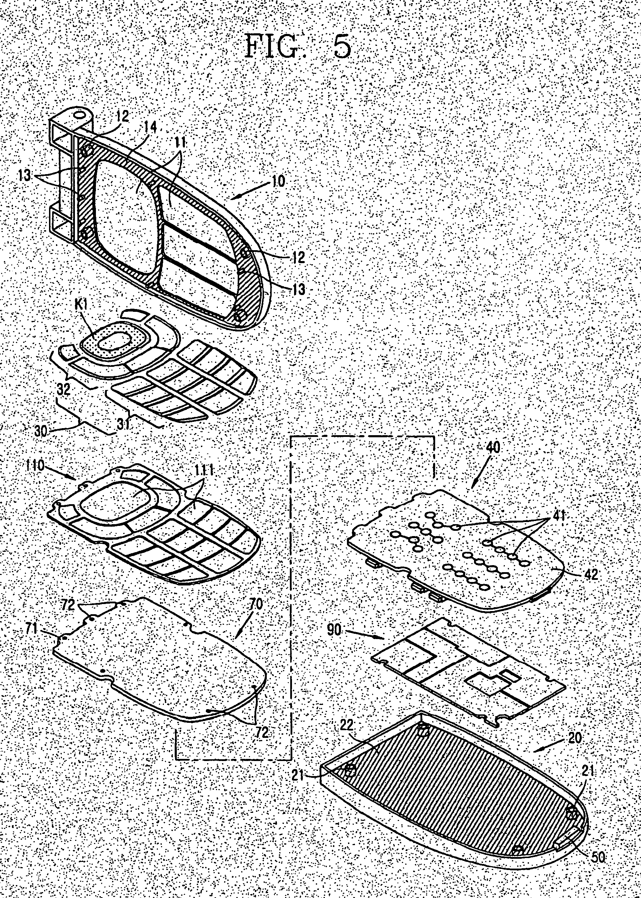

FIG. 5 is a disassembled perspective view showing a body of a mobile terminal having an electrostatic preventing apparatus according to the third embodiment of the present invention. The same reference numerals were given to the same parts as those of the aforementioned FIGs.

The front case 10, the rear case 20, the main board 40, and the inner cover 90 have the same constructions as those of the aforementioned FIGs. The key pad KP is composed of a pad 70 formed of a flexible material to have a certain thickness and an area, and a plurality of keys 30 attached to the pad 70. A conductive layer is formed on plural keys or the entire keys among the keys 30. The pad 70 is not provided with a conducting path.

A conducting plate 110 formed of a conductive material is coupled between the front case 10 and the key pad KP.

The conducting plate 110 is a thin plate corresponding to an external form of the pad 70, and is provided with key holes 111 corresponding to the keys 30 of the key pad KP therein. The conducting plate 110 is positioned at a surface of the pad 70 where the keys 30 are formed, and is coupled to the front case 10 with the key pad KP. The conducting plate 110 is connected to the ground path 14 of the front case 10.

An operation of the electrostatic preventing apparatus of the mobile terminal according to the third embodiment of the present invention will be explained as follows.

When electrostatic is applied to the periphery of the keys 30, the electrostatic flows on the ground pathes 14 and 22 formed at the casing through the conducting plate 110. Then, the electrostatic is discharged outward through the casing, the screws coupled to the casing, or the I/O connector 50 mounted at the casing.

An operation of the electrostatic preventing apparatus of the mobile terminal according to a fourth embodiment of the present invention will be explained as follows.

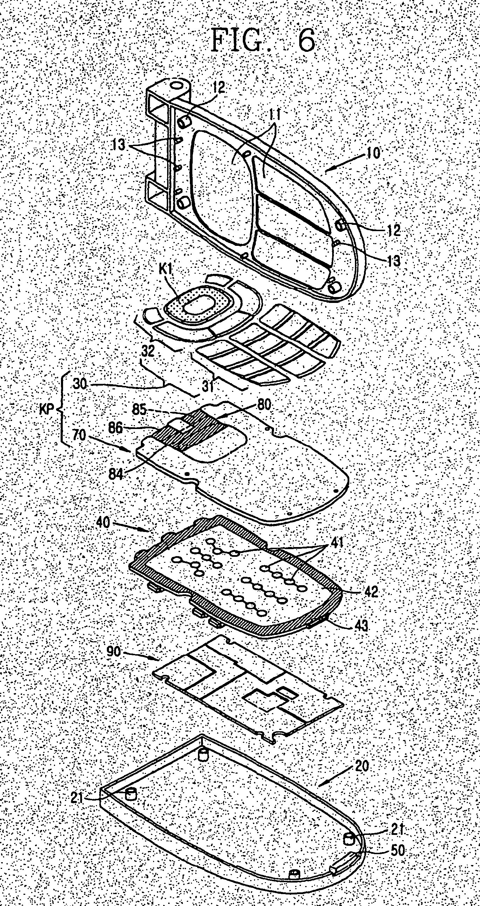

FIG. 6 is a disassembled perspective view showing a body of a mobile terminal having an electrostatic preventing apparatus according to the fourth embodiment of the present invention. The same reference numerals were given to the same parts as those of the aforementioned FIGs.

The front case 10 and the rear case 20 have the same constructions as those of the aforementioned FIGs except that the ground path is not provided.

The key pad KP mounted at the front case 10 is composed of a pad 70 formed of a flexible material to have a certain thickness and an area, and a plurality of keys 30 attached to the pad 70. The key pad KP is provided with a conducting path 80.

A conductive layer is formed on plural keys or the entire keys among the keys including number keys 31 and operation keys 32. In case that the conductive layer is formed on one key, the key is a key that has the largest area or that is the most frequently used among the operation keys 32. Hereinafter, the case that the conductive layer is formed on one key will be explained.

The conducting path 80 includes a third ground portion 84 formed at a region to which a key K1 on which a conductive layer is formed is attached as a certain shape, a fourth ground portions 85 formed at an opposite surface to a surface of the pad 70 to which the third ground portion 84 is attached as a certain shape, and a connection portion 86 for connecting the third ground portion 84 and the fourth ground portions 85 to each other. The connection portion 86 can be penetratingly formed at the pad 70, or can be formed at a side surface of the pad 70.

The conducting path 80 composed of the third ground portion 84, the fourth ground portion 85, and the connection portion 86 is formed of a thin plate. The thin plate is preferably formed of one of carbon, copper, gold, silver, etc. A resistance value of the conducting path 80 is preferably less than 10Ω.

As another modification example, the conducting path 80 provided at the key pad KP is formed of a conductive thin film tape (not shown) having a certain shape. The conductive thin film tape is attached to the pad 70.

When a conductive layer is formed on plural keys among the keys 30 of the key pad KP, the conducting path 80 is connected to the plural keys on which a conductive layer is formed.

The main board 40 includes a substrate 42 having a certain shape, components mounted at one side of the substrate 42, and a plurality of dome switches 41 provided at one surface of the substrate 42. The dome switches 41 are formed at positions corresponding to the keys 30 of the key pad KP. The substrate 42 is provided with a ground path 43. The ground path 43 is formed of a conductive thin film, and is formed to have a certain area at an edge of the substrate 42.

The conductive thin film is preferably formed by spraying an EMI material. The conductive thin film has preferably a resistance value less than 1.2Ω.

Preferably, the ground path 43 formed at the main board 40 is electrically connected to the I/O connector 50 mounted at the end of one side of the rear case 20.

Components of the electrostatic preventing apparatus of the mobile terminal according to the fourth embodiment of the present invention are assembled to one another as follows.

The front case 10, the rear case 20, the inner cover 90, the main board 40, and the key pad KP are assembled to one another in the same way as the aforementioned way.

The keys 30 are attached to the pad 70, and the key K1 on which a conductive layer is formed among the keys 30 is in contact with the third ground portion 84 of the conducting path 80.

The fourth ground portion 85 of the conducting path 80 formed at the key pad KP is in contact with the ground path 43 of the main board 40. Preferably, the ground path 43 of the main board 40 is electrically connected to the I/O connector 50 mounted at the casing.

An operation of the electrostatic preventing apparatus of the mobile terminal according to the fourth embodiment of the present invention will be explained as follows.

When electrostatic is applied to the periphery of the keys 30 as the mobile phone is in contact with an object or a user presses the keys 30, the electrostatic is introduced into the key K1 on which a conductive layer is formed. Then, the electrostatic flows on the ground path 43 formed at the main board through the conducting path 80 formed at the key pad KP, and then is discharged outward through the casing, the screws coupled to the casing, or the I/O connector 50 mounted at the casing.

In the electrostatic preventing apparatus of the mobile terminal provided with an electron emitting key pad 100 according to the fourth embodiment of the present invention, the pad 70 of the key pad KP is formed of a transparent material.

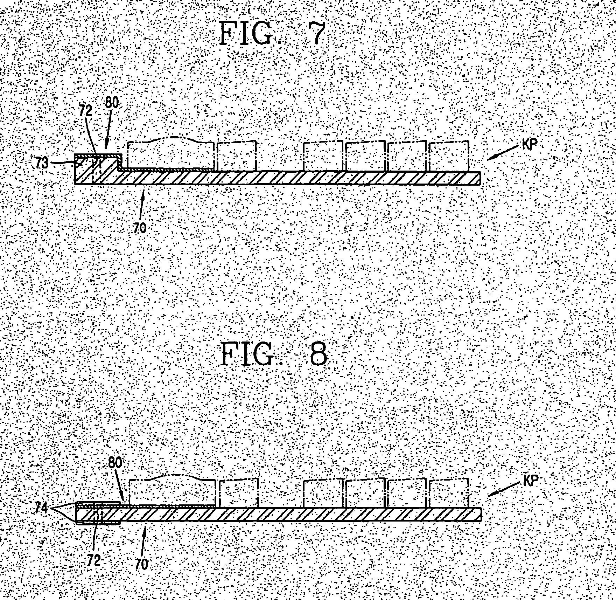

FIG. 7 shows another modification example of the key pad KP of the aforementioned embodiments of the present invention.

As shown, a protrusion portion 73 is formed at one side of the pad 70 constituting the key pad KP in order to better contact the conducting path 80 formed at the key pad KP to the ground path. The protrusion portion 73 is formed at one side of the conducting path 80 contacting the ground path.

FIG. 8 shows still another modification example of the key pad KP. As shown, a tape 74 formed of a conductive material is attached to one side of the key pad KP provided with conducting path 80. The tape 74 is attached to the pad 70 to be positioned at one side of the conducting path 80, and the tape 74 is protruded from the surface of the pad 70.

Preferably, a protrusion portion is formed at one side of the conducting plate 110 of the third embodiment in order to better contact the ground path 14 formed at the front case 10.

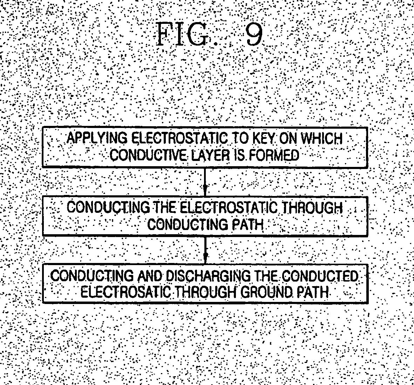

FIG. 9 is a flowchart showing a method for protecting electrostatic in a mobile terminal according to one embodiment of the present invention. As shown, the method for preventing electrostatic in a mobile terminal comprises applying electrostatic to a key on which a conductive layer is formed, conducting the electrostatic that has been applied to the key through a conducting path formed in a terminal body, and conducting and discharging the electrostatic that has been conducted through a ground path.

That is, when a user presses keys in order to use the mobile terminal, electrostatic generated by the user is conducted to a ground path through a conducting path and the conducted electrostatic is discharged through the ground path.

The ground path is provided at the casing constituting the terminal body, and a generated electrostatic is conducted and discharged through the ground path provided at the casing.

The ground path can be provided at the main board constituting the terminal body, and a generated electrostatic is conducted and discharged through the ground path provided at the main board.

Hereinafter, effects of the electrostatic preventing apparatus of the mobile terminal and the method thereof according to the present invention will be explained in more detail.

In the electrostatic preventing apparatus of the mobile terminal according to the present invention, when electrostatic is applied to the periphery of the keys, the electrostatic is discharged outward through the keys on which a conductive layer is formed, the conducting path, and the ground path. Accordingly, electrostatic is prevented from being transmitted to inner components of the mobile terminal, thereby preventing a mal-operation of software due to noise of the electrostatic, preventing a damage of hardware, and thus enhancing the reliability of the mobile terminal.

The electrostatic preventing apparatus of the present invention can be applied to a slider type terminal having keys or a folder type terminal having keys.

As the present invention may be embodied in several forms without departing from the essential characteristics thereof, it should also be understood that the above-described embodiments are not limited by any of the details of the foregoing description, unless otherwise specified, but rather should be construed broadly within its scope as defined in the appended claims, and therefore all changes and modifications that fall within the metes and bounds of the claims, or equivalence of such metes and bounds are therefore intended to be embraced by the appended claims.

## Claims

1. A mobile terminal capable of preventing mal-operation due to applied electrostatic comprising:
- a casing (10, 20);
- a key pad (KP) mounted in the casing (10, 20) and provided with one or more keys (30) on which a conductive layer is formed;
- a conducting path (80) formed at the key pad (KP) for contacting the conductive layer, and
- a main board (40) mounted in the casing (10, 20);
**characterized in that**
- an I/O connector (50) is mounted at the casing (10, 20), and
- a ground path (14, 22) is provided at an inner surface of the casing (10, 20) for conducting and discharging electrostatic of the conductive layer to a surface of the I/O connector (50).

2. The apparatus of claim 1, wherein the ground path (14, 22) is a conductive thin film formed in a region of the casing (10, 20).

3. The apparatus of claim 2, wherein the conductive thin film is formed by spraying an EMI material.

4. The apparatus of claim 1, wherein the casing (10, 20) comprises:
- a front case (10) including key holes (11) for inserting the keys (30); and
- a rear case (20) coupled to the front case (10) to form an inner space,
wherein the ground path (14) is provided at an inner surface of the front case (10).

5. The apparatus of claim 4, wherein the ground path (22) is further provided at an inner surface of the rear case (20), wherein the ground path (14) of the front case (10) and the ground path (22) of the rear case (20) are connected to each other.

6. The apparatus of claim 1, wherein the key pad (KP) comprises:
- a pad (70) formed of a flexible material; and
- a plurality of keys (30) attached to the pad (70), wherein
- the conducting path (80) is provided on the pad (70).

7. The apparatus of claim 6, wherein the conducting path (80) is formed from a conductive thin film.

8. The apparatus of claim 6, wherein the conducting path (80) is formed from one or more of carbon, copper, gold, and silver.

9. The apparatus of claim 1, wherein the conducting path (80) is formed at a contact surface of the key pad (70) and connecting to the key or keys (30) on which the conductive layer is formed.

10. The apparatus of claim 1, wherein the conducting path (80) comprises:
- a first ground portion (81) contacting the key or keys (30) on which the conductive layer is formed;
- a second ground portion (82) contacting the ground path (14); and
- a connection portion (83) for connecting the first ground portion (81) to the second ground portion (82).

11. The apparatus of claim 1, wherein the conducting path (80) is a conducting plate (110) inserted between the key pad (KP) and the casing (10, 20).

12. The apparatus of claim 1, wherein the conducting path (80) is a conductive tape attached to the key pad (KP).

13. The apparatus of claim 1, wherein the keys (30) comprise number keys (31) for inputting numbers or characters and operation keys (32) for inputting operation signals, wherein a conductive layer of metal is formed on one of the operation keys (32).

14. The apparatus of claim 1, wherein the ground path (22) is electrically connected to the I/O connector (50) by a conductive gasket (60).

15. The apparatus of claim 1, wherein the key pad (KP) is an electron emitting key pad (100).

16. The apparatus of claim 1, wherein the ground path (43) is formed on the main board (40), wherein the ground path (43) is a conductive thin film formed on an edge of the main board (40) contacting the key pad (KP).

17. The apparatus of claim 16, wherein the conductive thin film is formed by spraying an EMI material.

## Patentansprüche

1. Mobiles Endgerät geeignet zum Verhindern von Fehlfunktionen aufgrund zugeführter elektrostatischer Aufladung, umfassend:
- ein Gehäuse (10, 20);
- eine Tastatur (KP), die in dem Gehäuse (10, 20) angebracht und mit einer oder mehreren Tasten versehen ist, auf denen eine Leitungsschicht ausgebildet ist;
- eine Leiterbahn (80), die auf der Tastatur (KP) zum Kontaktieren der Leitungsschicht ausgebildet ist, und
- eine Hauptplatine (40), die in dem Gehäuse (10, 20) angebracht ist;
**dadurch gekennzeichnet, dass** ein I/O-Anschluss (50) an dem Gehäuse (10, 20) angebracht ist, und ein Erdungskontakt (14, 22) auf einer inneren Oberfläche des Gehäuses (10, 20) vorgesehen ist, um elektrostatische Aufladungen der Leitungsschicht zu einer Oberfläche des I/O-Anschlusses zu leiten und zu entladen.

2. Vorrichtung aus Anspruch 1,
wobei der Erdungskontakt (14, 22) eine in einem Bereich des Gehäuses (10, 20) ausgebildete leitende Dünnschicht ist.

3. Vorrichtung aus Anspruch 2,
wobei die leitende Dünnschicht durch Aufsprühen eines EMI-Materials ausgebildet ist.

4. Vorrichtung aus Anspruch 1,
wobei das Gehäuse (10, 20) umfasst:
- ein vorderes Gehäuse (10), das Ausnehmungen (11) zum Einbringen der Tasten (30) enthält; und
- ein hinteres Gehäuse (20), das mit dem vorderen Gehäuse (10) verbunden ist, um einen Innenraum auszubilden,
wobei der Erdungskontakt (14) auf einer inneren Oberfläche des vorderen Gehäuses (10) vorgesehen ist.

5. Vorrichtung aus Anspruch 4,
wobei der Erdungskontakt (22) ferner auf einer inneren Oberfläche des hinteren Gehäuses (20) vorgesehen ist, wobei der Erdungskontakt (14) des vorderen Gehäuses (10) und der Erdungskontakt (22) des hinteren Gehäuses (20) miteinander verbunden sind.

6. Vorrichtung aus Anspruch 1,
wobei die Tastatur (KP) umfasst:
- einen aus elastischem Material ausgebildeten Unterbau (70); und
- eine Vielzahl von auf dem Unterbau (70) angebrachten Tasten (30),
wobei die Leiterbahn (80) auf dem Unterbau (70) vorgesehen ist.

7. Vorrichtung aus Anspruch 6,
wobei die Leiterbahn (80) aus einer leitenden Dünnschicht gebildet ist.

8. Vorrichtung aus Anspruch 6,
wobei die Leiterbahn (80) aus einem oder mehreren von Kohlenstoff, Kupfer, Gold und Silber gebildet ist.

9. Vorrichtung aus Anspruch 1,
wobei die Leiterbahn (80) auf einer Kontaktoberfläche des Tastaturunterbaus (70) und zum Verbinden der Taste oder Tasten (30) ausgebildet ist, auf denen die Leitungsschicht ausgebildet ist.

10. Vorrichtung aus Anspruch 1,
wobei die Leiterbahn (80) umfasst:
- einen ersten Erdungsabschnitt (81) zum Kontaktieren der Taste oder Tasten (30), auf denen die Leitungsschicht ausgebildet ist;
- einen zweiten Erdungsabschnitt (82) zum Kontaktieren des Erdungskontakts (14); und
- einen Verbindungsabschnitt (83) zum Verbinden des ersten Erdungsabschnitts (81) mit dem zweiten Erdungsabschnitt (82).

11. Vorrichtung aus Anspruch 1,
wobei die Leiterbahn (80) eine zwischen der Tastatur (KP) und dem Gehäuse (10, 20) eingebrachte Leiterplatte (110) ist.

12. Vorrichtung aus Anspruch 1,
wobei die Leiterbahn (80) ein an der Tastatur (KP) angebrachtes leitendes Band ist.

13. Vorrichtung aus Anspruch 1,
wobei die Tasten (30) Nummerntasten (31) zur Eingabe von Nummern oder Zeichen und Funktionstasten (32) zur Eingabe von Funktionskennzeichen aufweisen,
wobei eine leitende Metallschicht auf einer der Funktionstasten (32) ausgebildet ist.

14. Vorrichtung aus Anspruch 1,
wobei der Erdungskontakt (22) durch eine leitfähige Dichtung (60) elektrisch mit dem I/O-Anschluss (50) verbunden ist.

15. Vorrichtung aus Anspruch 1,
wobei die Tastatur (KP) eine elektronenemittierende Tastatur (100) ist.

16. Vorrichtung aus Anspruch 1,
wobei der Erdungskontakt (43) auf der Hauptplatine (40) ausgebildet ist, wobei der Erdungskontakt (43) eine leitende Dünnschicht ist, die zum Kontaktieren der Tastatur (KP) an einer Kante der Hauptplatine (40) ausgebildet ist.

17. Vorrichtung aus Anspruch 16,
wobei die leitende Dünnschicht durch Aufsprühen eines EMI-Materials ausgebildet ist.

## Revendications

1. Terminal mobile apte à prévenir un dysfonctionnement dû à l'électrostatique appliquée comprenant :
- un boîtier (10, 20) ;
- un clavier (KP) monté dans le boîtier (10, 20) et prévu avec une ou plusieurs touches (30) sur laquelle/lesquelles une couche conductrice est formée ;
- un chemin conducteur (80) formé au niveau du clavier (KP) pour contacter la couche conductrice, et
- une carte principale (40) montée dans le boîtier (10, 20) ;
**caractérisé en ce que**
- un connecteur E/S (50) est monté au niveau du boîtier (10, 20), et
- un chemin de masse (14, 22) est prévu au niveau d'une surface interne du boîtier (10, 20) pour conduire et décharger l'électrostatique de la couche conductrice jusqu'à une surface du connecteur E/S (50).

2. Appareil selon la revendication 1, dans lequel le chemin de masse (14, 22) est un film mince conducteur formé dans une région du boîtier (10, 20).

3. Appareil selon la revendication 2, dans lequel le film mince conducteur est formé par pulvérisation d'un matériau EMI.

4. Appareil selon la revendication 1, dans lequel le boîtier (10, 20) comprend :
- un boîtier avant (10) incluant des trous de touches (11) pour insérer les touches (30) ; et
- un boîtier arrière (20) couplé au boîtier avant (10) pour former un espace intérieur, dans lequel le chemin de masse (14) est prévu au niveau d'une surface interne du boîtier avant (10).

5. Appareil selon la revendication 4, dans lequel le chemin de masse (22) est en outre prévu au niveau d'une surface interne du boîtier arrière (20), dans lequel le chemin de masse (14) du boîtier avant (10) et le chemin de masse (22) du boîtier arrière (20) sont connectés l'un à l'autre.

6. Appareil selon la revendication 1, dans lequel le clavier (KP) comprend :
- un clavier (70) formé d'un matériau flexible ; et
- une pluralité de touches (30) attachées au clavier (70), dans lequel
- le chemin conducteur (80) est prévu sur le clavier (70).

7. Appareil selon la revendication 6, dans lequel le chemin conducteur (80) est formé à partir d'un film mince conducteur.

8. Appareil selon la revendication 6, dans lequel le chemin conducteur (80) est formé à partir de l'un ou plusieurs du carbone, du cuivre, de l'or et de l'argent.

9. Appareil selon la revendication 1, dans lequel le chemin conducteur (80) est formé au niveau d'une surface de contact du clavier (70) et se connectant à la touche ou les touches (30) sur laquelle/lesquelles la couche conductrice est formée.

10. Appareil selon la revendication 1, dans lequel le chemin conducteur (80) comprend :
- une première partie de masse (81) au contact de la touche ou des touches (30) sur laquelle/lesquelles la couche conductrice est formée ;
- une deuxième partie de masse (82) au contact du chemin de masse (14) ; et
- une partie de connexion (83) pour connecter la première partie de masse (81) à la deuxième partie de masse (82).

11. Appareil selon la revendication 1, dans lequel le chemin conducteur (80) est une plaque conductrice (110) insérée entre le clavier (KP) et le boîtier (10, 20).

12. Appareil selon la revendication 1, dans lequel le chemin conducteur (80) est une bande conductrice attachée au clavier (KP).

13. Appareil selon la revendication 1, dans lequel les touches (30) comprennent des touches numériques (31) pour entrer des nombres ou des caractères et des touches opérationnelles (32) pour entrer des signaux d'opération, dans lequel une couche conductrice de métal est formée sur l'une des touches opérationnelles (32).

14. Appareil selon la revendication 1, dans lequel le chemin de masse (22) est électriquement connecté au connecteur E/S (50) par une rondelle conductrice (60).

15. Appareil selon la revendication 1, dans lequel le clavier (KP) est un clavier (100) émettant des électrons.

16. Appareil selon la revendication 1, dans lequel le chemin de masse (43) est formé sur la carte principale (40), dans lequel le chemin de masse (43) est un film mince conducteur formé sur un bord de la carte principale (40) au contact du clavier (KP).

17. Appareil selon la revendication 16, dans lequel le film mince conducteur est formé par pulvérisation d'un matériau EMI.
